# EUROPÄISCHE PATENTSCHRIFT

(11) **EP 1 325 509 B1**
(45) Veröffentlichungstag und Bekanntmachung des Hinweises auf die Patenterteilung: **09.12.2009**
(21) Anmeldenummer: 01964792.4
(22) Anmeldetag: 17.09.2001
(51) Int. Cl.: H01J 37/32, C23C 16/503

(54) **VERFAHREN UND VORRICHTUNG ZUR BEHANDLUNG VON OBERFLÄCHEN MIT HILFE EINES GLIMMENTLADUNGS-PLASMAS**
METHOD AND DEVICE FOR TREATING SURFACES USING A GLOW DISCHARGE PLASMA
PROCEDE ET DISPOSITIF POUR TRAITER DES SURFACES PAR PLASMA A DECHARGE LUMINEUSE

(30) Priorität: 22.09.2000 CH 185000
(43) Veröffentlichungstag der Anmeldung: 09.07.2003
(73) Patentinhaber: Tetra Laval Holdings & Finance SA, 1009 Pully (CH)
(72) Erfinder: SCHWARZENBACH, Walter, 38330 Saint-Nazaire les Eymes (FR); ROESSLER, Bertrand, 1723 Marly (CH); FAYET, Pierre, CH-1006 Lausanne (CH)
(74) Vertreter: Frei, Alexandra Sarah
(86) Internationale Anmeldenummer: PCT/CH2001/000559
(87) Internationale Veröffentlichungsnummer: WO 2002/025693

(56) Entgegenhaltungen:
- EP-A- 0 431 951
- EP-A- 0 725 163
- US-A- 4 634 601

## Beschreibung

Die Erfindung betrifft ein Verfahren und eine Vorrichtung gemäss den Oberbegriffen der entsprechenden Patentansprüche. Verfahren und Vorrichtung gemäss Erfindung dienen zur Oberflächenbehandlung mit reaktiven Teilchen aus einem Glimmentladungs-Plasma, insbesondere für die Behandlung von Oberflächen, die empfindlich sind auf thermische Belastung. Das Plasma, das in Verfahren und Vorrichtung gemäss Erfindung zur Anwendung kommt, ist ein sogenanntes Ein-Atmosphären-Plasma, das heisst ein Plasma, das in einem Gas bei einem Druck im Bereiche der Umgebungstemperatur (etwa 0,5 bis 1,5 bar oder 50'000 bis 150'000 Pa) aufrechterhalten wird.

Glimmentladungs-Plasmas werden in einem Gas aufrechterhalten mit Hilfe eines alternierenden elektrischen Feldes einer geeigneten Spannung und Frequenz durch das das Gas teilweise ionisiert wird und Ionen und Elektronen enthält nebst neutralen Atomen, Molekülen und Radikalen. Üblicherweise wird das Glimmentladungs-Plasma aufrechterhalten zwischen zwei plattenförmigen Elektroden, die mit der entsprechenden, elektrischen Energie versorgt werden und zwischen denen das Plasma lokalisiert ist.

Oberflächen werden mit reaktiven Teilchen aus Glimmentladungs-Plasmas behandelt um beispielsweise die Oberflächenenergie zu verändern (Veränderung der Benetzbarkeit), um die Oberflächen zu sterilisieren, um die Oberflächen zu ätzen oder um ein Material auf der Oberfläche abzuscheiden. Das Gas oder die Gasmischung, die im Plasma aufgespalten werden, und gegebenenfalls die Plasmaparameter werden gemäss der durch die Plasmabehandlung zu erreichenden Wirkung ausgewählt.

Üblicherweise hat das Gas, das im Plasma für die genannten Oberflächenbehandlungen aufgespalten wird, einen reduzierten Druck im Bereich von 1 mbar (100 Pa) oder weniger und die zu behandelnde Oberfläche wird entweder direkt dem Plasma ausgesetzt, indem sie zwischen den beiden Elektroden positioniert wird (direkte Plasmabehandlung), oder sie wird entfernt vom Plasma positioniert und das Gas wird von zwischen den Elektroden auf die zu behandelnde Oberfläche geleitet (indirekte Plasmabehandlung). Indirekte Plasmabehandlung wird gewählt beispielsweise aus geometrischen Gründen, zum Schutz der zu behandelnden Oberfläche vor Strahlung im Plasma oder für eine Behandlung mit nur einer Auswahl der reaktiven Teilchen, die im Plasma vorkommen (Auswahl der Teilchen mit einer längeren Lebenszeit).

Glimmentladungs-Plasma bei reduziertem Druck hat eine relativ niedrige Energiedichte und eine hohe Uniformität. Deshalb sind derartige Plasmas sehr geeignet für die Behandlung von Oberflächen, die auf thermische Beanspruchung empfindlich sind. Da aber die Drücke sehr niedrig sind, müssen die entsprechenden Apparaturen vakuumdicht sein und sind deshalb entsprechend aufwendig und teuer, insbesondere, wenn sie für grosse Oberflächen wie beispielsweise Bahnen von dünnen Materialien oder für grosse Zahlen von Gegenständen und relativ kurze Zykluszeiten (ohne Entlüftung der Apparatur zwischen Behandlungszyklen) ausgelegt werden sollen.

Eine beispielhafte Anwendung einer Plasma-unterstützten Oberflächenbehandlung ist die Beschichtung von dünnen Kunststofffolien (z.B. aus Polyethylen niedriger Dichte, aus Polypropylen, aus amorphem oder biaxial orientiertem Polyester, aus gegossenem oder biaxial ausgerichtetem Polyamid und mit einer Foliendicke von beispielsweise 80µm) mit einer Schicht (Barriereschicht) aus Siliziumoxid zur Reduktion der Gaspermeabilität der Folie. Der Prozess ist eine Plasma-unterstützte Abscheidung aus der Gasphase und die verwendete Gasmischung enthält nebst Sauerstoff und einem inerten Gas beispielsweise eine verdampfte Organosilizium-Verbindung. Ähnliche Prozesse werden auch angewendet für die Abscheidung von Barriereschichten aus Siliziumnitrid, Siliziumcarbid oder Kohlenstoff (amorph oder kristallin). Das für eine Kohlenstoffabscheidung verwendete Gasgemisch enthält leichte Kohlenwasserstoffe wie Methan, Ethylen Ethan etc.

Um derartige Prozesse durchzuführen, werden beispielsweise eine rotierende Trommel, die als die eine Elektrode dient, und eine Gegenelektrode mit einer entsprechend konkaven Elektrodenfläche verwendet, die in einem Vakuumkammer angeordnet sind. Das Folienmaterial wird auf der Trommeloberfläche aufliegend zwischen den beiden Elektroden durchgeführt, während die Gasmischung in den Raum zwischen den Elektroden gespeist wird. Üblicherweise sind auch die Vorratsrolle, von der das Folienmaterial abgespult wird, und eine Rolle zum Aufrollen des beschichteten Folienmaterials in der Vakuumkammer untergebracht.

Bekannterweise ist es auch möglich, Glimmentladungs-Plasmas in Gasen bei im wesentlichen Umgebungsdruck aufrechtzuerhalten. Ein in Luft von Umgebungsdruck aufrechterhaltenes Plasma wird für die Herstellung von Ozon verwendet. Für diesen Prozess ist es nicht von Bedeutung, dass diese Art von Ein-Atmosphären-Plasma sehr filamentös ist. Dies macht aber derartige Plasmas ungeeignet für Oberflächenbehandlungen, insbesondere für die Behandlung von empfindlichen Oberflächen. In den Publikationen US-5387842, US-5456972, US-5403453 und US-5414324, die in dieser Beschreibung mit beinhaltet sind, offenbart die Universität der Tenessee Research Corporation Methoden für die Herstellung von uniformeren Ein-Atmosphären-Plasmas (Plasma, das in einem Gas bei einem Druck von im wesentlichen Umgebungsdruck aufrechterhalten wird). Die erhöhte Uniformität dieser Plasmas wird erreicht, indem die Spannung und die Frequenz sehr sorgfältig an die Eigenschaften und den Druck der verwendeten Gasmischung angepasst werden. Gemäss den genannten Publikationen sind derartige Plasmas geeignet für Oberflächenbehandlungen, für die die zu behandelnde Oberfläche zwischen zwei entsprechend mit Energie versorgten Elektroden positioniert wird.

Aber es zeigt sich, dass die Uniformität derartiger Ein-Atmosphären-Plasmas sehr empfindlich ist gegen kleine Parameterveränderungen (Energie, Frequenz, Gaszusammensetzung, Gasdruck, Geometrie etc.), derart, dass es fast nicht möglich ist, ein solches Plasma in einem kontinuierlich arbeitenden System über eine längere Zeit absolut ohne Filamente aufrechtzuerhalten. Gemäss einer späteren Publikation der Universität der Tennessee Research Corporation (WO-99/40758) ist es schwierig, zu verhindern, dass an Rändern eines zu behandelnden Gegenstandes, an den Elektrodenrändem oder an den Folienrändern gelegentlich Plasmafilamente auftreten, wenn die zu behandelnde Oberfläche dem Plasma direkt ausgesetzt wird, das heisst, wenn der Gegenstand zwischen den Elektroden positioniert wird. Derartige gelegentliche Filamente werden aber sehr problematisch in den oben genannten Anwendungen für die Erstellung von Barriereschichten, in denen jedes Filament ein Loch in die Kunststofffolie brennt, wodurch in der Barriereschicht eine Öffnung und dadurch ein Leck entsteht, das, auch wenn es mikroskopisch klein ist, die Wirkung der Barriereschicht über eine grosse Fläche zunichte macht. Aus diesem Grunde scheint es kaum möglich, in direkten Plasmabehandlungen höchste Barrierequalitäten zu erreichen.

Aus diesem Grunde wird in der genannten Publikation WO-99/40758 vorgeschlagen, Oberflächenbehandlungen mit reaktiven Teilchen aus einem Ein-Atmosphären-Plasma als indirekte Plasmabehandlungen durchzuführen, insbesondere zur Behandlung von dünnen Kunststofffolien oder Geweben. Dies aber macht eine Behandlungs-Apparatur komplizierter und beschränkt die Verfügbarkeit der reaktiven Teilchen, insbesondere der sehr kurzlebigen Teilchen.

Die Erfindung stellt sich nun die Aufgabe, ein Verfahren und eine Vorrichtung für eine Oberflächenbehandlung unter Verwendung eines Ein-Atmosphären-Plasmas zu schaffen, wobei die Nachteile der direkten Plasmabehandlung (Behandlung zwischen den Elektroden) reduziert werden sollen, ohne die Komplikationen der indirekten Behandlung, wie sie der Stand der Technik vorschlägt, in Kauf nehmen zu müssen. Verfahren und Vorrichtung gemäss Erfindung sollen insbesondere geeignet sein für die Behandlung von dünnen Kunststofffolien, insbesondere für die Beschichtung von Bahnen derartiger Folienmaterialien mit einer Barriereschicht. Verfahren und Vorrichtung sollen einfach sein und sollen hohe Behandlungsqualitäten erlauben, insbesondere Behandlungen ohne die negativen Effekte von Plasmafilamenten.

Diese Aufgabe wird gelöst durch das Verfahren und die Vorrichtung, wie sie in den Patenansprüchen definiert sind.

Gemäss dem erfindungsgemässen Verfahren wird die zu behandelnde Oberfläche nicht in den Raum zwischen den für die Erzeugung des Plasmas verwendeten Elektroden positioniert sondern gerade ausserhalb dieses Raumes, das heisst auf einer Seite des Raumes zwischen den Elektroden gerade ausserhalb von zwei aufeinander ausgerichteten Kanten der Elektrodenflächen mit einem kleinen Abstand von diesen Kanten entfernt und gegen diese Kanten gerichtet. Dies bedeutet, dass die zu behandelnde Oberfläche in einem Randbereich des Plasmas positioniert ist, in welchem Randbereich das alternierende elektrische Feld eine Energiedichte aufweist, die genügt, um das Plasma aufrechtzuerhalten, in welchem Randbereich aber die Feldlinien sich nicht rechtwinklig zu den Elektrodenflächen erstrecken sondern sich zwischen den beiden aufeinander ausgerichteten Kanten der Elektrodenflächen krümmen (fringing field).

Das Behandlungsgas oder die Behandlungsgasmischung wird dem Raum zwischen den Elektroden vorteilhafterweise zugeführt von einem Randbereich, der der Position der zu behandelnden Oberfläche gegenüber liegt, und wird gegen die zu behandelnde Oberfläche bewegt.

Die erfindungsgemässe Vorrichtung weist zwei Plattenelektroden mit einer dielektrischen Beschichtung (Durchschlagsfestigkeit: 10 bis 80kV/mm) auf. Die Temperatur der Elektroden wird auf einem vorgegebenen Wert konstant gehalten (-80 bis 300°C). Die Elektrodenflächen der beiden Elektroden sind im wesentlichen parallel und gegeneinander gerichtet und weisen mindestens ein Paar von aufeinander ausgerichteten Kanten auf. Ferner weist die Vorrichtung Mittel auf zur Beaufschlagung der Elektroden mit einer Wechselspannung, die geeignet ist, ein Behandlungsgas oder eine Behandlungsgasmischung bei im wesentlichen Umgebungsdruck aufzuspalten, derart, dass zwischen den Elektrodenflächen ein Plasma entsteht. Dieses Plasma erstreckt sich sichtbar nicht nur im Raum zwischen den Elektrodenflächen sondern auch in Randbereichen, in denen es über aufeinander ausgerichtete Kanten der Elektrodenflächen vorsteht.

Die Vorrichtung weist ferner ein Positionierungsmittel auf für die Positionierung eines Substrates mit einer zu behandelnden Oberfläche derart, dass die genannte Oberfläche in einem Randbereich des Plasma liegt und gegen den Raum zwischen den Elektroden gerichtet ist. Das Zuführungsmittel zur Zuführung des Behandlungsgases oder der Behandlungsgasmischung in den Raum zwischen den zwei Elektrodenflächen ist vorteilhafterweise auf einer Seite des Plasmaraumes angeordnet, die der Position der zu behandelnden Oberfläche gegenüberliegt, und ist gegen den Raum zwischen den beiden Elektrodenflächen gerichtet.

Die zu behandelnde Oberfläche kann mit einem frei wählbaren Winkel zu den Elektrodenflächen positioniert werden. Vorteilhafterweise ist die zu behandelnde Oberfläche im wesentlichen senkrecht zu den Elektrodenflächen ausgerichtet, parallel zu dem Paar von aufeinander ausgerichteten Kanten der Elektrodenflächen und in einem kleinen Abstand (1 bis 10 mm) von diesen Kanten. Eine kleine, zu behandelnde Oberfläche kann stationär in diesem Plasma-Randbereich positioniert werden während einer Zeit, die für die Plasmabehandlung genügt. Eine grössere Oberfläche wird vorteilhafterweise in einer Richtung im wesentlichen senkrecht zu den Elektrodenflächen kontinuierlich durch den Randbereich gefördert, wobei die Fördergeschwindigkeit genügend klein ist, um jeden Teilbereich der zu behandelnden Oberfläche für eine für die Behandlung genügende Zeit dem Plasma auszusetzen.

Wenn das zu behandelnde Substrat eine Bahn eines Folienmaterials ist, ist es vorteilhaft, das Positionierungsmittel als rotierende Trommel auszubilden und die Folienbahn auf der Umfangsfläche der Trommel positioniert durch den Plasma-Randbereich zu bewegen. Das Elektrodenpaar ist relativ zur Trommel derart angeordnet, dass die Elektrodenflächen sich im wesentlichen radial zur Trommel erstrekken und die aufeinander ausgerichteten Kanten der beiden Elektroden sich parallel zur Trommelachse erstrecken und eine Länge haben, die mindestens der Breite der zu behandelnden Bahn entspricht. Der Abstand zwischen der Umfangsfläche der Trommel und den aufeinander ausgerichteten Kanten der Elektrodenflächen, die gegen die Trommel gerichtet sind, wird derart eingestellt, dass das Substrat, das auf der Trommel positioniert ist durch den Plasma-Randbereich bewegt wird, das heisst um einige Millimeter von den aufeinander ausgerichteten Kanten entfernt. Mindestens die Umfangsfläche der Trommel besteht aus einem elektrisch isolierenden Material. Eine metallene Trommel ist elektrisch geerdet, floating oder wird mit geeigneten Mitteln auf einer vorgegebenen Spannung gehalten. Ferner hat die Trommel eine geregelte Temperatur, die an das zu behandelnde Material angepasst ist.

Experimente zeigen, dass die Positionierung einer zu behandelnden Oberfläche in einem Plasma-Randbereich (fringing field) durch Plasmafilamente bedingte Schäden drastisch reduziert, wobei trotzdem Behandlungsgeschwindigkeiten (z.B. Abscheidungsgeschwindigkeiten) erreicht werden können, die in denselben Bereichen liegen wie Behandlungsgeschwindigkeiten für eine Positionierung zwischen den Elektroden.

Wenn eine dünne Kunststofffolie gemäss dem erfinderischen Verfahren mit einer Barriereschicht beispielsweise aus Siliziumoxid, Siliziumnitrid, Siliziumcarbid oder Kohlenstoff (amorph oder kristallin) beschichtet wird, hat das beschichtete Material eine konstant hohe Barrierequalität. Die Konstantheit der Barrierequalität ist wahrscheinlich bedingt durch die Abwesenheit von Plasmafilamenten im Plasma-Randbereich, in dem die zu behandelnde Oberfläche dem Plasma ausgesetzt wird. Dank der Abwesenheit von Plasmafilamenten werden Beschädigungen von Substrat und Beschichtung verhindert und die Abscheidung ist sehr regelmässig.

Für eine relativ lang dauernde Plasmabehandlung ist es vorteilhaft, eine Mehrzahl von Elektrodenpaaren hintereinander um denjenigen Teil der Umfangsfläche der Trommel anzuordnen, die den zu behandelnden Teil der Bahn trägt, und so die Plasmabehandlung in aufeinanderfolgenden Schritten durchzuführen. Es ist auch möglich, in solchen aufeinanderfolgenden Behandlungsschritten verschiedene Gase oder Gasmischungen zu verwenden, wodurch sich eine mehrstufige Behandlung ergibt mit beispielsweise den folgenden Schritten: Oberflächen-Vorbehandlung gefolgt von einer Mehrzahl von Beschichtungsschritten, in denen auf der Oberfläche des Substrates verschiedene Schichten aufeinander abgelagert werden.

Das erfindungsgemässe Verfahren ist aber nicht nur anwendbar für Oberflächenbeschichtungen in einem Plasma-unterstützten Abscheidungs-Prozess sondern auch in andern, an sich bekannten Plasma-unterstützten Prozessen beispielsweise zur Veränderung der Oberflächenenergie für eine Verbesserung der Benetzbarkeit, der Bedruckbarkeit oder einer darauffolgenden Beschichtung oder zur Dekontaminierung, Reinigung oder Sterilisation von Oberflächen, insbesondere von Temperatursensiblen Oberflächen.

Die erfindungsgemässe Vorrichtung wird im Zusammenhang mit den folgenden Figuren im Detail beschrieben. Dabei zeigen:
- **Figur 1**: in schematischer Weise ein Plasma, das zwischen zwei Plattenelektroden aufrechterhalten wird, und die Position einer nach dem erfindungsgemässen Verfahren zu behandelnden Oberfläche sowie eine vorteilhafte Position für die Gaszuführungsmittel;
- **Figur 2**: eine beispielhafte Ausführungsform der erfindungsgemässen Vorrichtung, die für die Plasmabehandlung der Oberfläche einer Materialbahn in einem kontinuierlichen Prozess ausgelegt ist;
- **Figur 3**: eine weitere, beispielhafte Ausführungsform der erfindungsgemässen Vorrichtung, die für eine mehrstufige Behandlung einer Materialbahn ausgelegt ist.

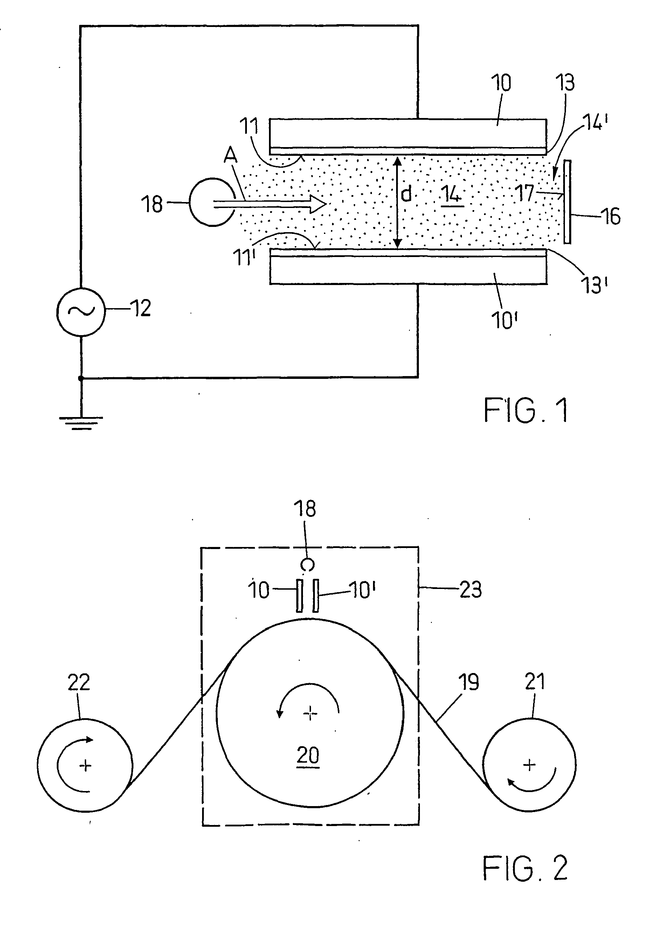

Figur 1 zeigt das Prinzip des erfindungsgemässen Verfahrens. Zwischen zwei Plattenelektroden 10 und 10' mit zwei Elektrodenflächen 11 und 11', die mit einem Abstand d voneinander im wesentlichen parallel zueinander angeordnet sind, wird ein Plasma gezündet und aufrechterhalten, dadurch, dass die Elektroden unter Spannung gesetzt werden mit Hilfe eines geeigneten Energieversorgungsmittels 12, das beispielsweise eine Spannungsquelle, einen Hochspannungstransformator und eine Anpassungsschaltung aufweist. Die Elektrodenflächen haben aufeinander ausgerichtete Kanten, insbesondere ein Paar von aufeinander ausgerichteten Kanten 13 und 13'. Die aufeinander ausgerichteten Kanten der Elektrodenflächen begrenzen zwischen einander einen Plasmaraum 14, wobei ein Plasma, das zwischen den beiden Plasmaflächen 11 und 11' aufrechterhalten wird, in Randbereichen 14' (fringing field) sichtbar über die Paare von aufeinander ausgerichteten Kanten 13 und 13' der Elektrodenflächen vorsteht.

Die Vorrichtung weist ferner ein Zuführungsmittel für die Zuführung eines Behandlungsgases oder einer Behandlungsgasmischung zum Plasmaraum 14, 14' und ein Positionierungsmittel zum Positionieren eines Substrates 16 mit einer zu behandelnden Oberfläche 17 auf. Das Positionierungsmittel ist ausgelegt für die Positionierung der zu behandelnden Oberfläche 17 in einem Randbereich 14' des Plasmaraumes und gegen den Raum zwischen den Elektroden 10 und 10' gerichtet. Vorteilhafterweise wird die zu behandelnde Oberfläche 17 im wesentlichen senkrecht zu den Elektrodenflächen 11 und 11' und im wesentlichen parallel zum nächsten Paar von aufeinander ausgerichteten Kanten 13 und 13' positioniert.

Das Zuführungsmittel ist ausgelegt für die Zuführung eines Behandlungsgases oder einer Behandlungsgasmischung in den Plasmaraum 14, 14' von derjenigen Seite, die dem Randbereich14', in dem die zu behandelnde Oberfläche 17 positioniert ist, gegenüber liegt. Vorteilhafterweise wird das Gas vom Zuführungsmittel gegen die zu behandelnde Oberfläche 17 gefördert (Pfeil A). Das Zuführungsmittel weist beispielsweise ein Gaszuführungsrohr 18 auf, das parallel zu einem Paar von aufeinander ausgerichteten Kanten der Elektrodenflächen angeordnet ist und in regelmässigen Abständen Gasaustrittsöffnungen aufweist. Für die Zuführung einer Gasmischung kann es vorteilhaft sein, eine Mehrzahl von parallel verlaufenden Gaszuführungsrohren vorzusehen und die Komponenten der Mischung separat zuzuführen.

Figur 2 zeigt eine beispielhafte Ausführungsform der erfindungsgemässen Vorrichtung, welche Ausführungsform sich eignet für die Behandlung der einen Oberfläche einer Bahn eines flächigen Materials 19. Wie schon weiter oben beschrieben, weist die Vorrichtung ein Paar von Elektroden 10 und 10' auf und ein Gaszuführungsrohr18. Ferner weist sie eine rotierende Trommel 20 auf, die als Positionierungsmittel für die in einem Randbereich eines zwischen den Elektroden 10 und 10' aufrechterhaltenen Plasmas zu behandelnde Oberfläche dient. Die Bahn wird der Trommel von einer Zuführungsrolle 21 zugeführt, läuft für die Behandlung im Randbereich des zwischen den Elektroden 10 und 10' aufrechterhaltenen Plasmas über einen Teil der Umfangsfläche der Trommel 20 und wird nach der Behandlung auf der Rolle 22 aufgerollt.

Wenn das Behandlungsgas nicht Luft ist und die Präsenz von Luft eine negative Wirkung auf die Behandlung hat, muss die Vorrichtung oder mindestens Teile der Vorrichtung in einem Gehäuse 23 mit Entlüftungsmittel untergebracht werden. In den meisten Fällen wird es nicht notwendig sein, das Gehäuse dicht zu gestalten; in keinem Falle ist es notwendig, das Gehäuse vakuumdicht zu gestalten.

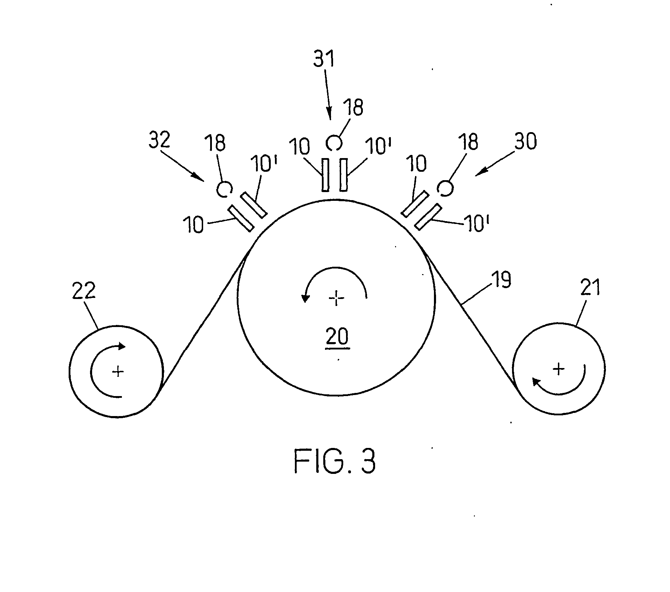

Figur 3 zeigt eine weitere, beispielhafte Ausführungsform der erfindungsgemässen Vorrichtung. Diese Vorrichtung ist gleich wie die Vorrichtung gemäss Figur 2 mit der Ausnahme, dass anstelle von nur einem Paar von Elektroden für die Erzeugung eines Plasmas beispielsweise drei solche Paare 30, 31 und 32 vorgesehen sind, wodurch sich die Vorrichtung eignet für die Behandlung einer Bahn 19 in einem dreistufigen Behandlungsprozess, in dem die drei Behandlungsschritte alle dieselben sein können oder verschieden.

Eine Vorrichtung, wie sie im wesentlichen in der Figur 2 dargestellt ist, wird beispielsweise mit den folgenden Parametern betrieben:

| | |
|---|---|
| Distanz zwischen den Elektrodenflächen: | 1 bis 10 mm |
| | |
| Distanz zwischen den Kanten der Elektrodenflächen und der zu behandelnden Oberfläche: | 1 bis 10 mm |
| | |
| Angelegte Spannung: | 10 bis 20 kV |
| | |
| Angelegte Frequenz: | 1 bis 10 kHz |
| | |
| Gasgemisch für Beschichtung mit Siliziumoxid: | Sauerstoff, Stickstoff, Hexamethylsiloxan |

Resultate für die Beschichtung einer PET-Folie mit einer Dicke von 12 µm mit einer Barriereschicht aus Siliziumoxid:

| | |
|---|---|
| Beschichtungsdicke: | 30 bis 130 nm |
| | |
| Durchlässigkeit für Sauerstoff (unbeschichtet): | 120 cm³/(Tag m² atm) |
| | |
| Durchlässigkeit für Sauerstoff (beschichtet): | 20 bis 0,01 cm³/(Tag m² atm) |

Die Sauerstoff-Durchlässigkeit einer Folie mit einer Barriereschicht, die in einer erfindungsgemässen Behandlung mit Hilfe eines Ein-Atmosphären-Plasmas beschichtet wurde, hält einem Vergleich mit einer entsprechenden Folie, die in einem Vakuum-Plasma behandelt wurde, sehr wohl stand. Die Durchlässigkeit ist mindestens zwanzig mal besser als die Durchlässigkeit derselben Folie, die zwischen den Elektroden positioniert in einem Ein-Atmosphären-Plasma behandelt wurde.

## Patentansprüche

1. Verfahren zur Behandlung einer Oberfläche (17) mit Hilfe eines Behandlungs-gases oder einer Behandlungsgasmischung, die in einem Glimmentladungs-Plasma aufgespalten werden, welches Plasma zwischen zwei im wesentlichen parallel einander gegenüber angeordneten, einen Plasmaraum (14) definierenden Elektrodenflächen (11, 11') von zwei geeignet unter Spannung gesetzten Elektroden (10, 10') aufrechterhalten wird, **dadurch gekennzeichnet, dass** die zu behandelnde Oberfläche (17) in einem Randbereich (14') des Plasmaraumes (14) ausserhalb von zwei aufeinander ausgerichteten Kanten (13, 13') der Elektrodenflächen (11, 11') positioniert wird, wobei die zu behandelnde Oberfläche (17) gegen die genannten Kanten (13, 13') gerichtet und von diesen beabstandet ist, und wobei die Energiedichte im Randbereich (14') für die Aufrechterhaltung des Plasmas genügt.

2. Verfahren nach Anspruch 1, **dadurch gekennzeichnet, dass** das Behandlungs-gas oder die Behandlungsgasmischung einen Druck von 50'000 bis 150'000 Pa hat.

3. Verfahren nach einem der Ansprüche 1 bis 2, **dadurch gekennzeichnet, dass** das Behandlungsgas oder die Behandlungsgasmischung dem Plasmaraum (14) zugeführt wird von einer Seite, die dem Randbereich (14'), in dem die zu behandelnde Oberfläche (17) positioniert ist, gegenüberliegt, und durch den Plasmaraum (14) gegen die zu behandelnde Oberfläche (17) bewegt wird.

4. Verfahren nach einem der Ansprüche 1 bis 3, **dadurch gekennzeichnet, dass** die zu behandelnde Oberfläche (17) im Plasma-Randbereich (14') im wesentlichen senkrecht zu den Elektrodenflächen (11, 11') der Elektroden (10, 10') positioniert wird.

5. Verfahren nach Anspruch 4, **dadurch gekennzeichnet, dass** die zu behandelnde Oberfläche (17) während der Behandlung in einer Richtung senkrecht zu den Elektrodenflächen (11, 11') gefördert wird.

6. Verfahren nach Anspruch 5, **dadurch gekennzeichnet, dass** die zu behandelnde Oberfläche (17) die eine Oberfläche einer Kunststofffolien-Bahn (19) ist.

7. Verfahren nach einem der Ansprüche 1 bis 6, **dadurch gekennzeichnet, dass** mindestens ein Teil der Komponenten der Behandlungsgasmischung dem Plasmaraum (14) separat zugeführt wird.

8. Verfahren nach einem der Ansprüche 1 bis 7, **dadurch gekennzeichnet, dass** die Oberflächenbehandlung eine chemische Abscheidung aus der Gasphase ist, in der eine Barriereschicht aus Siliziumoxid, aus Siliziumnitrid, aus Siliziumcarbid oder aus Kohlenstoff abgeschieden wird.

9. Verfahren nach einem der Ansprüche 1 bis 7, **dadurch gekennzeichnet, dass** die Oberflächenbehandlung eine mehrstufige Abscheidung aus der Gasphase ist, in der eine Mehrzahl von Schichten abgeschieden wird.

10. Verfahren nach einem der Ansprüche 1 bis 7, **dadurch gekennzeichnet, dass** die Oberflächenbehandlung eine Veränderung der Oberflächenenergie, eine Oberflächendekontaminierung, eine Oberflächenreinigung oder eine Oberflächensterilisation ist.

11. Vorrichtung für die Behandlung einer Oberfläche (17) mit Hilfe eines Glimmentladungs-Plasmas, das zwischen zwei Elektroden (10, 10') mit je einer Elektrodenfläche (11, 11') aufrechterhalten wird, welche Vorrichtung mindestens ein Paar von zwei Elektroden mit je einer Elektrodenfläche (11, 11') aufweist, wobei die zwei Elektroden (10, 10') derart angeordnet sind, dass ihre Flächen (11, 11') im wesentlichen parallel zueinander und gegeneinander gerichtet sind und zwischen sich einen Plasmaraum (14) definieren, welche Vorrichtung ferner geeignete Versorgungsmittel (12) aufweist, mit deren Hilfe das mindestens eine Paar von Elektroden (10, 10') unter Spannung gesetzt wird, um ein Gas im Raum zwischen der Elektrodenflächen (11, 11') der Elektroden (10, 10') des Paars zu einem Glimmentladungs-Plasma aufzuspalten, und welche Vorrichtung ferner ein Zuführungsmittel zur Zuführung eines Behandlungsgases oder einer Behandlungsgasmischung in den Raum zwischen den Elektrodenflächen (11, 11') und ein Positionierungsmittel zur Positionierung der zu behandelnden Oberfläche (17) im Plasma aufweist, **dadurch gekennzeichnet, dass** das Positionierungsmittel ausgestaltet ist für eine Positionierung der zu behandelnden Oberfläche (17) ausserhalb eines Paars von aufeinander ausgerichteten Kanten (13, 13') der Elektrodenflächen (11, 11') auf einer Seite des Plasmaraumes (14), gegen das genannte Kantenpaar (13, 13') gerichtet und mit einem Abstand von diesem, wobei der genannte Abstand an Vorrichtungsparameter derart angepasst ist, dass das Plasma sich bis zur Position der zu behandelnden Oberfläche erstreckt.

12. Vorrichtung nach Anspruch 11, **dadurch gekennzeichnet, dass** das Positionierungsmittel derart ausgestaltet ist, dass der Abstand zwischen der zu behandelnden Oberfläche (17) und dem Paar von aufeinander ausgerichteten Kanten (13, 13'), das gegen die zu behandelnde Oberfläche (17) gerichtet ist, zwischen 1 und 10 mm beträgt.

13. Vorrichtung nach einem der Ansprüche 11 oder 12, **dadurch gekennzeichnet, dass** das Zuführungsmittel ausgestaltet ist für eine Zuführung des Behandlungsgases oder der Behandlungsgasmischung von einer weiteren, der Seite des Positionierungsmittels gegenüberliegenden Seite des Plasmaraumes (14, 14') in den Plasmaraum (14, 14') und für eine Bewegung des Gases oder der Gasmischung in einer Richtung (A) gegen das Positionierungsmittel.

14. Vorrichtung nach einem der Ansprüche 11 bis 13, **dadurch gekennzeichnet, dass** das Positionierungsmittel für eine kontinuierliche Förderung der zu behandelnden Oberfläche (17) in einer im wesentlichen senkrecht zu den Elektrodenflächen (11, 11') ausgerichteten Richtung ausgestaltet ist.

15. Vorrichtung nach Anspruch 14, **dadurch gekennzeichnet, dass** das Positionierungsmittel eine rotierende Trommel (20) ist und dass die Elektrodenflächen (11, 11') im wesentlichen radial zur Trommel (20) ausgerichtet sind.

16. Vorrichtung nach einem der Ansprüche 11 bis 15, **dadurch gekennzeichnet, dass** das Zuführungsmittel mindestens ein Zuführungsrohr (18) aufweist, das parallel zu den Elektrodenflächen (11, 11') angeordnet ist und das gegen den Plasmaraum (14) gerichtete Zuführungsöffnungen aufweist.

17. Verwendung einer Vorrichtung nach einem der Ansprüche 11 bis 16 für die Beschichtung einer Kunststofffolie mit einer Barriereschicht aus Siliziumoxid, Siliziumnitrid, Siliziumcarbid oder Kohlenstoff in einer Plasma-unterstützten chemischen Abscheidung aus der Gasphase.

18. Verwendung einer Vorrichtung nach einem der Ansprüche 14 bis 16 für die Beschichtung einer Bahn einer Kunststofffolie mit einer Barriereschicht aus Siliziumoxid, Siliziumnitrid, Siliziumcarbid oder Kohlenstoff in einer kontinuierlichen, Plasma-unterstützten Abscheidung aus der Gasphase.

## Claims

1. Method for treating a surface (17) with the aid of a treatment gas or treatment gas mixture being broken down in a glow discharge plasma sustained between two substantially parallel opposite faces (11, 11') of two suitably energized electrodes (10, 10') defining a plasma space (14), **characterized in that** the surface (17) to be treated is positioned in an edge region (14') of the plasma space (14) beyond two aligned edges (13, 13') of the electrode faces (11, 11'), said surface (17) facing towards these edges (13, 13') and being positioned at a distance from these edges (13, 13'), wherein the power density in the edge region (14') is sufficient for sustaining a plasma.

2. Method according to claim 1, **characterized in that** the treatment gas or treatment gas mixture has a pressure of between 50,000 and 150,000 Pa.

3. Method according to one of claims 1 or 2, **characterized in that** the treatment gas or treatment gas mixture is fed to the plasma space (14) from a side opposite the edge region (14') in which the surface (17) to be treated is positioned and is flown through the plasma space (14) towards the surface (17) to be treated.

4. Method according to one of claims 1 to 3, **characterized in that** the surface (17) to be treated is positioned in the edge region (14') substantially perpendicularly to the faces (11, 11') of the electrodes (10, 10').

5. Method according to claim 4, **characterized in that** the surface (17) to be treated is advanced in a direction perpendicular to the electrode faces (11, 11') during treatment.

6. Method according to one of claims 5, **characterized in that** the surface (17) to be treated is one of the two surfaces of a web (19) of plastic film.

7. Method according to one of claims 1 to 6, **characterized in that** at least part of the components of the treatment gas mixture are fed to the plasma space (14) separately.

8. Method according to one of claims 1 to 7, **characterized in that** the surface treatment is a chemical vapor deposition in which a barrier layer of silicon oxide, of silicon nitride, of silicon carbide or of carbon is deposited.

9. Method according to one of claims 1 to 7, **characterized in that** the surface treatment is a multistep vapor deposition in which a plurality of layers is deposited.

10. Method according to one of claims 1 to 7, **characterized in that** the surface treatment comprises surface energy modification, surface decontamination, surface cleaning or surface sterilization.

11. Device for treating a surface (17) with the aid of a glow discharge plasma being sustained between two plate electrodes (10, 10'), the device comprising at least one pair of two electrodes (10, 10') with one electrode face (11, 11') each, the two electrodes (10, 10') being arranged with their faces (11, 11') opposite to each other and substantially parallel to each other and defining a plasma space (14), and the device further comprising suitable energizing means (12) for energizing the at least one electrode pair (10, 10') in order to break down a gas in the space between the faces (11, 11') of the electrodes (10, 10') of the pair to form a glow discharge plasma, and the device further comprising feed means for feeding a treatment gas or a treatment gas mixture to the space between the electrode faces (10, 10') and positioning means for positioning the surface (17) to be treated in the plasma, **characterized in that** the positioning means are designed for positioning the surface (17) to be treated beyond a pair of aligned edges (13, 13') of the electrode faces (11, 11') at one side of the plasma space (14), at a distance from said pair of edges (13, 13') and facing said pair of edges (13, 13'), said distance being matched to device parameters such that the plasma is sustained in the position of the surface to be treated.

12. Device according to claim 11, **characterized in that** the positioning means is designed such that the distance between the surface (17) to be treated and the pair of aligned edges (13, 13') facing towards the surface (17) to be treated is between 1 and 10 mm.

13. Device according to one of claims 11 or 12, **characterized in that** the feed means are designed for feeding the treatment gas or treatment gas mixture to the plasma space (14, 14') from a further side of the plasma space (14) opposite to the side of the positioning means and for flowing the gas or gas mixture in a direction (A) towards the side of the positioning means.

14. Device according to one of claims 11 to 13, **characterized in that** the positioning means is designed to continuously advance the surface (17) to be treated in a direction substantially perpendicular to the electrode faces (11, 11').

15. Device according to claim 14, **characterized in that** the positioning means is a rotating drum (20) and that the electrode faces (11, 11') are oriented substantially radially relative to the drum (20).

16. Device according to one of claims 11 to 15, **characterized in that** the feed means is at least one feed tube (18) arranged parallel to the electrode faces (11,11') and having feed holes directed towards the plasma space (14).

17. Use of a device according to one of claims 11 to 16 for coating a plastic film with a barrier layer of silicon oxide, of silicon nitride, of silicon carbide or of carbon in a plasma enhanced chemical vapor deposition process.

18. Use of a device according to one of claims 14 to 16 for coating a web of plastic film with a barrier layer of silicon oxide, of silicon nitride, of silicon carbide or of carbon in a continuous plasma enhanced chemical vapor deposition process.

## Revendications

1. Procédé de traitement d'une surface (17) au moyen d'un gaz de traitement ou d'un mélange de gaz de traitement qui sont dissociés dans un plasma de décharge corona, le plasma étant maintenu entre les surfaces (11, 11') de deux électrodes (10, 10') placées sous tension appropriée, disposées parallèlement l'une à l'autre et définissant une chambre (14) à plasma,
**caractérisé en ce que**
la surface (17) à traiter est placée dans une bordure (14') de la chambre (14) à plasma à l'extérieur de deux bords (13, 13') des surfaces d'électrode (11, 11') disposés face à face, la surface (17) à traiter étant orientée vers lesdits bords (13, 13') et étant maintenue à distance de ces derniers, la densité d'énergie dans la bordure (14') étant suffisante pour maintenir le plasma.

2. Procédé selon la revendication 1, **caractérisé en ce que** le gaz de traitement ou le mélange de gaz de traitement présente une pression de 50 000 à 150 000 Pa.

3. Procédé selon l'une des revendications 1 à 2, **caractérisé en ce que** le gaz de traitement ou le mélange de gaz de traitement sont apportés dans la chambre (14) à plasma par un côté opposé à la bordure (14') dans laquelle la surface (17) à traiter est placée et est déplacé dans la chambre (14) à plasma en direction de la surface (17) à traiter.

4. Procédé selon l'une des revendications 1 à 3, **caractérisé en ce que** la surface (17) à traiter est placée dans la bordure (14') du plasma essentiellement perpendiculairement aux surfaces (11, 11') des électrodes (10, 10').

5. Procédé selon la revendication 4, **caractérisé en ce que** pendant le traitement, la surface (17) à traiter est transportée dans une direction perpendiculaire aux surfaces (11, 11') des électrodes.

6. Procédé selon la revendication 5, **caractérisé en ce que** la surface (17) à traiter est une surface d'une bande (19) de feuille en matière synthétique.

7. Procédé selon l'une des revendications 1 à 6, **caractérisé en ce qu'**au moins une partie des composants du mélange de gaz de traitement est apportée séparément dans la chambre (14) à plasma.

8. Procédé selon l'une des revendications 1 à 7, **caractérisé en ce que** le traitement de surface est un dépôt chimique en phase gazeuse dans lequel une couche de barrière en oxyde de silicium, en nitrure de silicium, en carbure de silicium et/ou en carbone est déposée.

9. Procédé selon l'une des revendications 1 à 7, **caractérisé en ce que** le traitement de surface est un dépôt en phase gazeuse en plusieurs étapes dans lequel plusieurs couches sont déposées.

10. Procédé selon l'une des revendications 1 à 7, **caractérisé en ce que** le traitement de surface est une modification de l'énergie de surface, une décontamination de la surface, un nettoyage de la surface ou une stérilisation de la surface.

11. Dispositif de traitement d'une surface (17) au moyen d'un plasma de décharge corona qui est maintenu entre deux électrodes (10, 10') qui présentent chacune une surface d'électrode (11, 11'), lequel dispositif présente au moins une paire constituée de deux électrodes qui présentent chacune une surface d'électrode (11, 11'), les deux électrodes (10, 10') étant disposées de telle sorte que leurs surfaces (11, 11') sont orientées essentiellement parallèlement l'une à l'autre et sont disposées face à face en définissant entre elles une chambre (14) à plasma, le dispositif présentant en outre des moyens d'alimentation (12) appropriés à l'aide desquels la ou les paires d'électrodes (10, 10') sont placées sous tension pour dissocier un gaz en un plasma de décharge corona dans l'espace situé entre les surfaces d'électrode (11, 11') des électrodes (10, 10') de la paire, le dispositif présentant en outre un moyen d'amenée qui amène un gaz de traitement ou un mélange de gaz de traitement dans l'espace situé entre les surfaces d'électrode (11, 11') et un moyen de positionnement qui positionne la surface (17) à traiter dans le plasma, **caractérisé en ce que**
le moyen de positionnement est configuré pour positionner la surface (17) à traiter à l'extérieur de deux bords (13, 13') des surfaces d'électrode (11, 11') disposés face à face sur un côté de la chambre (14) à plasma, l'orienter vers ladite paire de bords (13, 13') et la maintenir à distance de ces derniers, ladite distance étant adaptée à des paramètres du dispositif de telle sorte que le plasma s'étende jusqu'à la position dans laquelle se trouve la surface à traiter.

12. Dispositif selon la revendication 11, **caractérisé en ce que** le moyen de positionnement est configuré de telle sorte que la distance entre la surface (17) à traiter et la paire de bords (13, 13') disposés face à face et orientés en direction de la surface (17) à traiter est comprise entre 1 et 10 mm.

13. Dispositif selon l'une des revendications 11 ou 12, **caractérisé en ce que** le moyen d'amenée est configuré pour amener le gaz de traitement ou le mélange de gaz de traitement dans la chambre à plasma (14, 14') depuis un autre côté de la chambre à plasma (14, 14'), opposé au côté du moyen de positionnement, et pour déplacer le gaz ou le mélange de gaz dans une direction (A) orientée vers le moyen de positionnement.

14. Dispositif selon l'une des revendications 11 à 13, **caractérisé en ce que** le moyen de positionnement est configuré pour transporter en continu la surface (17) à traiter dans une direction orientée essentiellement à la perpendiculaire des surfaces d'électrode (11, 11').

15. Dispositif selon la revendication 14, **caractérisé en ce que** le moyen de positionnement est un tambour rotatif (20) et **en ce que** les surfaces d'électrode (11, 11') sont orientées essentiellement radialement par rapport au tambour (20).

16. Dispositif selon l'une des revendications 1 à 15, **caractérisé en ce que** le moyen d'amenée présente au moins un tube d'amenée (18) disposé parallèlement aux surfaces d'électrode (11, 11') et dont des ouvertures d'amenée sont orientées en direction de la chambre (14) à plasma.

17. Utilisation d'un dispositif selon l'une des revendications 11 à 16 pour le revêtement d'une feuille en matière synthétique par une couche de barrière constituée d'oxyde de silicium, de nitrure de silicium, de carbure de silicium ou de carbone par dépôt chimique en phase gazeuse assisté par plasma.

18. Utilisation d'un dispositif selon l'une des revendications 14 à 16, pour le revêtement d'une bande de feuille de matière synthétique par une couche de barrière en oxyde de silicium, en nitrure de silicium, en carbure de silicium ou en carbone par dépôt continu en phase gazeuse assisté par plasma.
